# EUROPÄISCHE PATENTSCHRIFT

(11) **EP 4 102 244 B1**
(45) Veröffentlichungstag und Bekanntmachung des Hinweises auf die Patenterteilung: **17.01.2024**
(21) Anmeldenummer: 21178419.4
(22) Anmeldetag: 09.06.2021
(51) Int. Cl.: G01R 33/565, G01R 33/54, G01R 33/56

(54) **COMPUTERIMPLEMENTIERTES VERFAHREN ZUR EINSTELLUNG EINES SICHTFELDS FÜR EINE MAGNETRESONANZAUFNAHME, MAGNETRESONANZEINRICHTUNG, COMPUTERPROGRAMM UND ELEKTRONISCH LESBARER DATENTRÄGER**
COMPUTER-IMPLEMENTED METHOD FOR ADJUSTING A FIELD OF VIEW FOR MAGNETIC RESONANCE RECORDING, MAGNETIC RESONANCE DEVICE, COMPUTER PROGRAM, AND ELECTRONICALLY READABLE DATA CARRIER
PROCESSUS MIS EN OEUVRE PAR ORDINATEUR PERMETTANT DE DÉFINIR UN CHAMP DE VISION POUR UN ENREGISTREMENT PAR RÉSONANCE MAGNÉTIQUE, UN DISPOSITIF DE RÉSONANCE MAGNÉTIQUE, PROGRAMME INFORMATIQUE ET SUPPORT DE DONNÉES LISIBLE DE MANIÈRE ÉLECTRONIQUE

(43) Veröffentlichungstag der Anmeldung: 14.12.2022
(73) Patentinhaber: Siemens Healthcare GmbH, 91052 Erlangen (DE)
(72) Erfinder: Paul, Dominik, 91088 Bubenreuth (DE); Fautz, Hans-Peter, 91301 Forchheim (DE); Grodzki, David, 91058 Erlangen (DE); Hale, Hannah, 91054 Buckenhof (DE); Zeller, Mario, 91054 Erlangen (DE)
(74) Vertreter: Siemens Healthineers Patent Attorneys

(56) Entgegenhaltungen:
- DE-A1-102016 218 536
- US-A1- 2016 313 434
- SIMON J DORAN ET AL: "A complete distortion correction for MR images: I. Gradient warp correction; Gradient warp correction of MR images", PHYSICS IN MEDICINE AND BIOLOGY, INSTITUTE OF PHYSICS PUBLISHING, BRISTOL GB, Bd. 50, Nr. 7, 7. April 2005 (2005-04-07), Seiten 1343-1361, XP020084555, ISSN: 0031-9155, DOI: 10.1088/0031-9155/50/7/001

## Beschreibung

Die Erfindung betrifft ein computerimplementiertes Verfahren zur Einstellung eines Sichtfelds für eine Magnetresonanzaufnahme, insbesondere eines Patienten, mit einer Magnetresonanzeinrichtung, welche eine Gradientenspulenanordnung zur Erzeugung von bei der Magnetresonanzaufnahme zur Ortscodierung zu verwendenden Gradientenfeldern und eine Steuereinrichtung aufweist, wobei die Steuereinrichtung zur Verzerrungskorrektur aufgenommener Magnetresonanzdatensätze zumindest für durch Imperfektionen der Gradientenfelder verursachte Verzerrungen anhand einer Verzerrungskarte ausgebildet ist. Daneben betrifft die Erfindung eine Magnetresonanzeinrichtung, ein Computerprogramm und einen elektronisch lesbaren Datenträger.

Die Magnetresonanzbildgebung ist eine insbesondere im medizinischen Bereich etablierte Bildgebungsmodalität. Dabei werden Spins innerhalb des Untersuchungsobjekts, insbesondere eines Patienten, in einem starken Grundmagnetfeld (BO-Feld) ausgerichtet. Durch von einer entsprechenden Hochfrequenzspulenanordnung ausgesendete Hochfrequenzpulse kann eine Anregung der Spins erfolgen, wobei der Zerfall der Anregung als Magnetresonanzsignal gemessen werden kann. Um auch den Ort einer Messung bestimmen zu können, ist es bekannt, mittels einer Gradientenspulenanordnung Gradientenfelder zu erzeugen, die zur Ortskodierung verwendet werden. Dabei sollen die Gradientenfelder so erzeugt werden, dass eine möglichst genaue Linearität gegeben ist, während für das Grundmagnetfeld gelten soll, dass dieses möglichst homogen sein soll.

Allerdings kann es zum einen zu Abweichungen von der Homogenität des Grundmagnetfeldes kommen, insbesondere auch durch das Untersuchungsobjekt selbst, zum anderen jedoch können Imperfektionen der Gradientenfelder auftreten, die insbesondere durch eine Abweichung von der Linearität gegeben sind. Beide Effekte können zu Verzerrungen bei der Ortskodierung führen. Durch so genannten Verzerrungskorrekturen (auch als Verzeichniskorrekturen oder englisch "distortion correction" bezeichnet) können die Nichtlinearitäten unter Zuhilfenahme von abgespeicherten Verzerrungsinformationen, insbesondere einer Verzerrungskarte, durch bildbasierte Verschiebungen der entsprechenden Bildpunkte beseitigt werden. Beispielsweise ist es im Stand der Technik bekannt, anhand eines Phantoms, dessen Geometrie zumindest bezüglich einiger Markerpunkte bekannt ist, eine Kalibrierungsmessung vorzunehmen, um eine Verzerrungskarte zumindest bezüglich der Imperfektionen der Gradientenfelder für eine bestimmte Magnetresonanzeinrichtung zu bestimmen. Die Verzerrungskarte beschreibt dann durch entsprechende Verzerrungskoeffizienten, wie welcher Bildpunkt zu verschieben ist.

Problematisch hierbei ist, dass es je nach Richtung der Bildpunktverschiebung zur Reduktion des eigentlich eingestellten, meist rechtwinklig bzw. quaderförmig definierten Sichtfelds kommen kann. Das bedeutet, aufgrund der Verzerrung sind bestimmte Bereiche am Rand von Magnetresonanzdatensätzen nicht bei der Magnetresonanzaufnahme abgebildet worden, so dass für diese nicht abgebildeten Bereiche keine Information vorliegt.

Diese Problematik tritt verstärkt bei Messungen in Randbereichen des Homogenitätsvolumens sowie bei moderneren, eher offen und frei gestalteten Magnetresonanzeinrichtungen auf. Dabei könnte der Benutzer gegebenenfalls seinen Erfahrungsschatz nutzen, um das Sichtfeld größer abzuschätzen und zu planen, muss dabei jedoch immer sehr genau wissen, wie viel Verlust durch die Verzerrung auftritt. Dies ist jedoch schicht- und positionsabhängig, so dass die Abschätzung sehr erschwert wird. Zudem bringt nicht jeder Benutzer eine derartige Erfahrung mit sich.

US 2016 313 434 A1 offenbart ein Verfahren zur Korrektur von Bildverzerrungen eines aufgenommenen Bildes in einem MRT-System, wobei die Bildverzerrungen durch Nichtlinearitäten in einem Gradientenfeld von den Gradientenspulen verursacht werden.

Der Erfindung liegt daher die Aufgabe zugrunde, eine verbesserte Möglichkeit zur Einstellung von Sichtfeldern an einer Magnetresonanzeinrichtung für aufgrund von Imperfektionen von Gradientenfeldern von Verzerrungen betroffene Aufnahmebereiche anzugeben.

Diese Aufgabe wird erfindungsgemäß gelöst durch ein computerimplementiertes Verfahren, eine Magnetresonanzeinrichtung, ein Computerprogramm und einen elektronisch lesbaren Datenträger gemäß den unabhängigen Ansprüchen. Vorteilhafte Ausgestaltungen ergeben sich aus den Unteransprüchen.

Bei einem Verfahren der eingangs genannten Art ist erfindungsgemäß vorgesehen, dass durch die Steuereinrichtung
- auf Basis der Verzerrungskarte für wenigstens einen ersten Satz von ein rechteckiges oder quaderförmiges, ursprüngliches Sichtfeld beschreibenden Sichtfeldparametern eine Ausschlussinformation, die einen aufgrund der Verzerrung nicht abgebildeten Bereich des ursprünglichen Sichtfelds beschreibt, ermittelt wird,
- unter Verwendung der Ausschlussinformation ein zweiter, für die Magnetresonanzaufnahme zu nutzender Satz von Sichtfeldparametern bestimmt wird, und
- die Magnetresonanzaufnahme unter Verwendung des zweiten Satzes von Sichtfeldparametern erfolgt,
wobei das ursprüngliche, einzustellende Sichtfeld in einer Benutzeroberfläche, insbesondere gemeinsam mit einer Anatomie des aufzunehmenden Patienten, auf einer Anzeigeeinrichtung angezeigt wird, wobei die Ausschlussinformation zur Anzeige des nicht abgebildeten Bereichs gemäß der Ausschlussinformation und/oder zur Anpassung der Begrenzung der Sichtfeldanzeige zum Ausschluss des nicht abgebildeten Bereichs verwendet wird, wobei bei einer Änderung des einzustellenden Sichtfelds aufgrund einer Benutzereingabe die das veränderte einzustellende Sichtfeld beschreibenden Sichtfeldparameter als neuer erster Satz zur Aktualisierung der Ausschlussinformation verwendet werden, woraufhin der nicht abgebildete Bereich aufgrund der aktualisierten Ausschlussinformation für das veränderte einzustellende Sichtfeld angezeigt wird.

Die Verzerrungskarte ist zumindest hinsichtlich der Imperfektionen der Gradientenfelder als magnetresonanzeinrichtungsspezifisch anzusehen, das bedeutet, eine beispielsweise aufgrund einer Kalibrierung ermittelte Verzerrungskarte ist bekannt und liegt in einem Speichermittel der Steuereinrichtung vor. Damit ist auch im Rahmen der Verzerrungskorrektur genutztes Wissen darüber bekannt, welche Ortsverschiebungen tatsächlich auftreten. Die der Erfindung zugrunde liegende Idee ist es nun, dieses Wissen der Verzerrungskarte bereits im Vorfeld einer Magnetresonanzaufnahme zu nutzen, um eine verbesserte Einstellung des Sichtfelds zu ermöglichen. Hierfür wird vorgeschlagen, für ein beispielsweise vorgegebenes bzw. benutzerseitig ausgewähltes Sichtfeld, das üblicherweise rechteck- bzw. quaderförmig gewählt wird, zu ermitteln, welche Anteile des Sichtfelds bei einer Magnetresonanzaufnahme mit dieser Sichtfeldeinstellung nicht abgebildet würden (nicht abgebildeter Bereich) und welche Anteile abgebildet würden (abgebildeter Bereich). Dabei sei angemerkt, dass sowohl der nicht abgebildete Bereich als auch der abgebildete Bereich durchaus aus mehreren, räumlich getrennten Teilbereichen bestehen können, beispielsweise gegenüberliegenden Randteilbereichen des nicht abgebildeten Bereichs.

Während es grundsätzlich denkbar ist, den nicht abgebildeten Bereich und somit auch den abgebildeten Bereich des ursprünglichen Sichtfelds durch Anwendung der Verzerrungskarte auf das ursprüngliche Sichtfeld bzw. dessen Bildpunkte und Vergleich des Ergebnisses mit dem ursprünglichen Sichtfeld zu ermitteln, sieht dennoch eine bevorzugte, im Folgenden noch genauer dargelegte Variante der vorliegenden Erfindung vor, eine inverse Verzerrungskorrektur auf Basis der inversen Verzerrungskarte auf das Sichtfeld anzuwenden, mithin sozusagen die zur Ortsverschiebung verwendete Verzerrungsfunktion umzukehren. Denn auch dann wird deutlich, welche der innerhalb des ursprünglichen Sichtfelds liegenden Bildpunkte nach außerhalb des Sichtfelds abgebildet würden.

Die entstehende Ausschlussinformation, die letztlich eine Aufteilung des ursprünglichen Sichtfelds im abgebildeten und nicht abgebildeten Bereich beschreibt, kann im Rahmen der vorliegenden Erfindung auf vielfältige Weise vorteilhaft genutzt werden, um letztlich einen insbesondere gegenüber dem ersten Satz von Sichtfeldparametern veränderten zweiten Satz von Sichtfeldparametern, der dann für die Magnetresonanzaufnahme verwendet wird, zu ermitteln. Insbesondere ist eine Nutzung sowohl zur Unterstützung eines Benutzers bei der Auswahl eines letztendlich zu nutzenden Sichtfelds denkbar als auch eine automatische Verbesserung des vorgegebenen und/oder benutzerseitig ausgewählten Sichtfelds, insbesondere auch in Kombination, beispielsweise zur Unterbreitung eines Vorschlags an den Benutzer. Auf diese Weise erlaubt es die Erfindung insgesamt, verbessert sicherzustellen, dass die gewünschten Inhalte abgebildet werden und zeitaufwändige Wiederholungsaufnahmen vermieden werden.

Erfindungsgemäß wird das ursprüngliche, einzustellende Sichtfeld in einer Benutzeroberfläche, insbesondere gemeinsam mit einer Anatomie des aufzunehmenden Patienten, auf einer Anzeigeeinrichtung angezeigt, wobei die Ausschlussinformation zur Anzeige des nicht abgebildeten Bereichs gemäß der Ausschlussinformation und/oder zur Anpassung der Begrenzung der Sichtfeldanzeige zum Ausschluss des nicht abgebildeten Bereichs verwendet wird. Im Rahmen der Planung von Magnetresonanzuntersuchungen wird häufig eine Benutzeroberfläche verwendet, in der auch Sichtfelder in einer entsprechenden grafischen Darstellung in der Benutzeroberfläche visualisiert und somit vereinfacht darstellbar werden. Beispielsweise erfolgt eine Darstellung der Anatomie des Patienten, sei es schematisch anhand eines Modells oder aber, bevorzugt, anhand wenigstens einer Localizer-Aufnahme, in die ein einzustellendes Sichtfeld, beispielsweise als rechteckiger überlagerter Rahmen, eingeblendet wird. Diesbezüglich kann nun in zweierlei Hinsicht eine Unterstützung des einstellenden Benutzers erfolgen. So kann zum einen der nicht abgebildete Bereich, der durch die Verzerrung verloren geht, markiert werden, wobei beispielsweise vorgesehen sein kann, dass der nicht abgebildete Bereich farbig hinterlegt dargestellt wird. Beispielsweise können in Randbereichen des weiterhin insbesondere rechteckig dargestellten Sichtfelds Einfärbungen bzw. Überlagerungen dort erfolgen, von wo aufgrund der Verzerrung bei der aktuellen Sichtfeldeinstellung keine Magnetresonanzdaten ermittelt werden können. In einer anderen Ausgestaltung ist es aber auch möglich, von der rechteckigen bzw. quaderförmigen Darstellung des Sichtfelds dahingehend abzuweichen, dass die dargestellte Außenform nur noch die auch tatsächlich mit den entsprechenden Einstellungen abgedeckten, mithin abgebildeten, Bereiche anzeigt. In diesem Fall stehen keine rechtwinkligen Planungsobjekte mehr zur Verfügung, allerdings wird eine zusätzliche Information vermittelt. Selbstverständlich können beide Optionen auch kombiniert werden, so dass letztendlich beispielsweise der farblich markierte, nicht abgebildete Bereich formangepasste Sichtfelder zu ihrer ursprünglichen Planungsform, insbesondere Rechtecke und/oder Quadrate, ergänzt.

Erfindungsgemäß wird, wenn ein Benutzer eine Änderung vornimmt, eine entsprechende Aktualisierung der Visualisierung des nicht abgebildeten Bereichs erfolgen. Konkret werden bei einer Änderung des einzustellenden Sichtfelds aufgrund einer Benutzereingabe die das veränderte einzustellende Sichtfeld beschreibenden Sichtfeldparameter als neuer erster Satz zur Aktualisierung der Ausschlussinformation verwendet, woraufhin der nicht abgebildete Bereich aufgrund der aktualisierten Ausschlussinformation für das veränderte einzustellende Sichtfeld angezeigt wird. Auf diese Weise kann der Benutzer sozusagen "ausprobieren", welche Veränderungen in dem abgebildeten und dem nicht abgebildeten Bereich sich bei einer Anpassung von verschiedenen Sichtfeldparametern ergeben.

Konkret kann die Ermittlung des zweiten Satzes von Sichtfeldparametern basierend auf einer benutzerseitigen Auswahl eines Sichtfelds erfolgen, bei einer wie soeben beschriebenen Anzeige beispielsweise als das schlussendlich ausgewählte Sichtfeld. Jedoch kann auch bei einer automatischen Ermittlung beispielsweise von einer benutzerseitigen Auswahl ausgegangen werden, wie im Folgenden noch genauer beschrieben wird; insbesondere kann eine zweckmäßige, allgemeine Weiterbildung der Erfindung jedoch auch vorsehen, dass der zweite Satz von Sichtfeldparametern erst nach einer Bestätigung durch den Benutzer verwendet wird, was insbesondere bei einer automatischen Ermittlung des zweiten Satzes durch die Steuereinrichtung zweckmäßig ist. Das Sichtfeld des zweiten Satzes von Sichtfeldparameter und/oder der zweiten Satz von Sichtfeldparametern selbst können dem Benutzer also als Vorschlag präsentiert werden, den dieser annehmen kann.

In einer konkreten Ausgestaltung der vorliegenden Erfindung kann vorgesehen sein, dass basierend auf einer benutzerseitigen Wahl des ursprünglichen Sichtfelds durch die Steuereinrichtung automatisch ein zweiter Satz von Sichtfeldparametern derart ermittelt wird, dass der dargestellte Bereich des zugehörigen Sichtfelds das gesamte ausgewählte, ursprüngliche Sichtfeld umfasst. In diesem Fall ist eine automatische Anpassung gegeben, die sicherstellt, dass das im benutzerseitig gewollten ursprünglichen Sichtfeld Enthaltene auch tatsächlich in der Magnetresonanzaufnahme abgebildet wird.

Konkret kann in diesem Zusammenhang vorgesehen sein, dass eine schrittweise Vergrößerung ausgehend von dem ausgewählten, ursprünglichen Sichtfeld in zumindest einer Dimension, in der am Rand nicht abgebildeter Bereich vorliegt, zur Auswahl von zu überprüfenden ersten Sichtfeldparametersätzen erfolgt, bis ein geeigneter zweiter Satz von Sichtfeldparametern aufgefunden wird. Bevorzugt ist es im Rahmen der vorliegenden Erfindung jedoch, wenn die Ermittlung des nicht abgebildeten Bereichs durch Anwendung der inversen Verzerrungskorrektur gemäß der Verzerrungskarte auf das ursprüngliche Sichtfeld erfolgt und der zweite Satz von Sichtfeldparametern so gewählt wird, dass das zugehörige Sichtfeld das Anwendungsergebnis vollständig umfasst. Die Anwendung der inversen Verzerrungskorrektur, also die letztlich umgekehrte Ortsverschiebung im Vergleich zur eigentlichen Verzerrungskarte, zeigt, welche Anteile des ursprünglichen Sichtfelds aus diesem heraus verschoben würden und mithin bei einer Magnetresonanzaufnahme mit diesem ursprünglichen Sichtfeld nicht dargestellt würden, da sie von außerhalb aufgenommen werden müssten. Wird das schließlich zu verwendende Sichtfeld, beschrieben durch den zweiten Satz von Sichtfeldparametern, aber unmittelbar so gewählt, dass die durch die inverse Verzerrungskorrektur aus dem ursprünglichen Sichtfeld heraus verschobenen Bildpunkte allesamt enthalten sind, beispielsweise als das kleinste alle diese Punkte umfassende Rechteck bzw. der kleinste alle diese Punkte umfassende Quader, kann auf einfache Weise ohne schrittweises Vorgehen unmittelbar "abgelesen" werden, welches erweiterte Sichtfeld benötigt wird.

Eine besonders bevorzugte Weiterbildung der vorliegenden Erfindung sieht vor, dass basierend auf einer Untersuchungsinformation, die in der Magnetresonanzaufnahme zu zeigende Merkmale, insbesondere anatomische Merkmale, beschreibt, durch die Steuereinrichtung automatisch, ausgehend von einem ursprünglichen, diese Merkmale ohne Berücksichtigung der Verzerrung enthaltenden und/oder benutzerseitig ausgewählten Sichtfeld überprüft wird, ob der abgebildete Bereich dieses ursprünglichen Sichtfelds alle zu zeigenden Merkmale umfasst, wobei bei nicht alle zu zeigenden Merkmale umfassendem abgebildeten Bereich
- automatisch ein zweiter Satz von Sichtfeldparametern derart ermittelt wird, dass der abgebildete Bereich des zugehörigen Sichtfelds alle zu zeigenden Merkmale umfasst, und/oder
- ein Warnhinweis an den Benutzer ausgegeben wird.

Diese wie weitere Ausgestaltungen der vorliegenden Erfindung, die im Folgenden noch diskutiert werden, gehen letztendlich davon aus, dass bereits Informationen zum aufzunehmenden Untersuchungsobjekt, insbesondere dem Patienten, vorliegen, die eine Verortung der zu zeigenden Merkmale erlauben. Beispielsweise kann die Planung eines Sichtfelds für die Magnetresonanzaufnahme eines Patienten an einem bereits aufgenommenen Magnetresonanzbild, beispielsweise ein Localizer-Bild und/oder einem sonstigen zuvor aufgenommenen Magnetresonanzdatensatz, erfolgen. In diesem können bereits Segmentierungen anatomischer Merkmale möglich sein, sei es bevorzugt automatisch, sei es manuell und/oder durch Kombination automatischen und manuellen Vorgehens. Ist aber bekannt, wo in einem ursprünglichen Sichtfeld diese zu zeigenden Merkmale enthalten sind, kann auch überprüft werden, ob sie in dem zugehörigen abgebildeten Bereich enthalten sind oder durch die Verzerrung gerade nicht abgebildet werden können. Beispielsweise kann hier bei Anwendung der inversen Verzerrungskorrektur auf diese Merkmale umfassende Bildpunkte überprüft werden, ob die Bildpunkte durch die inverse Verzerrungskorrektur aus dem ursprünglichen Sichtfeld (selbstverständlich ohne Berücksichtigung der Verzerrung betrachtet) herausverschoben werden. Ist dies der Fall, kann automatisch ein neues Sichtfeld, beschrieben durch einen zweiten Satz von Sichtfeldparametern, derart ermittelt werden, dass alle zu zeigenden Merkmale entsprechend enthalten sind; zusätzlich oder alternativ kann ein Warnhinweis an den Benutzer ausgegeben werden, welcher diesen anregen kann, das Sichtfeld entsprechend anzupassen, beispielsweise unterstützt durch die bereits beschriebenen Visualisierungen nicht abgebildeter Bereiche.

Der vorliegende Ansatz kann besonders zweckmäßig auch im Rahmen einer Bildkontrolle herangezogen werden, insbesondere im Hinblick auf notwendige Folgeaufnahmen. So sieht eine Weiterbildung der Erfindung vor, dass der erste Satz von Sichtfeldparametern ein genutztes, ursprüngliches Sichtfeld einer bereits erfolgten Magnetresonanzaufnahme beschreibt, wobei durch die Steuereinrichtung automatisch ein Aktionskriterium ausgewertet wird, das überprüft, ob der Anteil des nicht abgebildeten Bereichs an dem genutzten Sichtfeld, welches ohne Berücksichtigung der Verzerrung betrachtet wird, einen Schwellwert überschreitet und/oder wenigstens ein gemäß einer oder der Untersuchungsinformation in der Magnetresonanzaufnahme zu zeigendes Merkmal wenigstens teilweise in dem nicht abgebildeten Bereich liegt, wobei bei Erfüllung des Aktionskriteriums automatisch ein für eine noch zu erfolgende Magnetresonanzaufnahme zu verwendender zweiter Satz von Sichtfeldparametern derart ermittelt wird, dass der Anteil des nicht abgebildeten Bereichs an dem genutzten, ursprünglichen Sichtfeld, dieses wiederum ohne Berücksichtigung der Verzerrung betrachtet, einen weiteren oder den Schwellwert unterschreitet und/oder der abgebildete Bereich des dem zweiten Satz von Sichtfeldparametern zugehörigen Sichtfelds alle zu zeigenden Merkmale umfasst. In einer solchen nachgelagerten automatisierten Bildkontrolle kann also anhand des Aktionskriteriums erkannt werden, dass Bereiche abgeschnitten wurden, woraufhin dem Benutzer ein Vorschlag für eine verbesserte wiederholte Messung unterbreitet werden kann. Dieser kann dem Vorschlag dann beispielsweise zustimmen und die Zweitmessung kann vorgenommen werden.

Wie bereits dargelegt wurde, ist es im Rahmen der vorliegenden Erfindung besonders bevorzugt, wenn die Ermittlung des nicht abgebildeten Bereichs durch Anwendung der inversen Verzerrungskorrektur gemäß der Verzerrungskarte erfolgt. Dabei ergibt sich die besonders vorteilhafte Möglichkeit, diese inverse Verzerrungskorrektur auf ein Maskenbild des ursprünglichen Sichtfelds zur Ermittlung eines Ergebnisbildes anzuwenden, wobei die außerhalb des ursprünglichen Sichtfelds ohne Berücksichtigung der Verzerrung liegenden Anteile des Ergebnisbildes als nicht abgebildeter Bereich identifiziert werden. Ein Maskenbild ist dabei insbesondere so zu verstehen, dass, beispielsweise aufgrund einer binären Ausgestaltung, relevante Bildpunkte von nicht relevanten Bildpunkten im ursprünglichen Sichtfeld unterschieden werden können. Anders gesagt bedeutet dies, dass die Ermittlung des nicht abgebildeten Bereichs auf relevante Anteile des ursprünglichen Sichtfelds beschränkt werden kann, indem beispielsweise bei einer binären Maske nur die auch im Ergebnisbild mit "1" als relevant markierten Anteile bei der Ermittlung des nicht abgebildeten Bereichs berücksichtigt werden.

Dabei kann konkret vorgesehen sein, dass das Maskenbild auf Basis eines Modells und/oder einer bereits erfolgten Magnetresonanzaufnahme derart bestimmt wird, dass es anzeigt, wo im ursprünglichen Sichtfeld ohne Berücksichtigung der Verzerrung, insbesondere aufzunehmende, Anteile des Patienten, beispielsweise gemäß der Untersuchungsinformation zu zeigende Merkmale, vorliegen, wobei zur Ermittlung des nicht abgebildeten Bereichs nur aufzunehmende Anteile des Patienten gemäß dem Maskenbild berücksichtigt werden. Dabei können aufzunehmende Anteile des Patienten selbstverständlich auch durch die oben bereits genannten, zu zeigenden Merkmale gemäß der Untersuchungsinformation gegeben sein. Konkret kann das Maskenbild beispielsweise derart ermittelt werden, dass der Patient insgesamt segmentiert wird, mithin zwischen Luft/Umgebung und Patient unterschieden wird, was beispielsweise auf einer Localizer-Aufnahme leicht möglich ist. Nicht abgebildete Bildpunkte außerhalb des Patienten sind nicht relevant, so dass auf diese Art beispielsweise die Betrachtung auf den Patienten selbst eingeschränkt werden kann, der nicht abgebildete Bereich also nicht abgebildete Anteile des Patienten allgemein beschreibt. Möglich ist es jedoch auch, zu zeigende anatomische Merkmale zu definieren, beispielsweise bestimmte Organe und/oder Gewebeanteile. Diese können ebenso beispielhaft im Magnetresonanzdatensatz einer bereits erfolgten Magnetresonanzaufnahme segmentiert werden, wobei alternativ oder zusätzlich selbstverständlich auch Modelle, beispielsweise ein anatomischer Atlas, herangezogen werden können, um zumindest eine Abschätzung vorzunehmen. Dabei kann auch ein "Sicherheitsbereich" um das Segmentierungsergebnis als Toleranz mit zu dem Merkmal gezählt werden. Denkbar ist es auch, jedoch weniger bevorzugt, allein oder hauptsächlich modellbasiert zu arbeiten, beispielsweise durch Anpassung eines anatomischen Atlanten auf einen aktuellen Patienten, insbesondere unter Nutzung entsprechender Patienteninformationen.

Wie bereits bezüglich des gesamten Sichtfelds dargelegt wurde, kann auch im Rahmen der Ausgestaltung mit einem Maskenbild mit besonderem Vorteil vorgesehen sein, dass automatisch ein zweiter Satz von Sichtfeldparametern bestimmt wird, indem ausgehend von dem ursprünglichen Sichtfeld ein erweitertes Sichtfeld derart bestimmt wird, dass es alle nicht abgebildeten Bereiche umfasst. In diesem Fall muss mithin nicht das gesamte ursprüngliche Sichtfeld umfasst sein, sondern die Betrachtung wird mit besonderem Vorteil auf tatsächlich relevante Anteile, beispielsweise die, die den Patienten allgemein zeigen und/oder bestimmte zu zeigende Merkmale, eingeschränkt. So wird eine Vergrößerung des Sichtfelds nur dann und in dem Maße vorgenommen, wenn und soweit relevante Merkmale betroffen sind.

Eine Weiterbildung der Erfindung sieht vor, dass bei Vergrö-βerung des durch den zweiten Satz von Sichtfeldparametern beschriebenen Sichtfelds gegenüber dem ursprünglichen Sichtfeld die Auflösung erhöht wird, insbesondere entsprechend dem Grad der Vergrößerung. Zwar ist es grundsätzlich denkbar, die gleiche Auflösung beizubehalten, jedoch zweckmäßiger, die Auflösung entsprechend zu vergrößern, so dass der Benutzer den erwarteten Bildeindruck auch trotz des vergrößerten Sichtfelds erhalten kann. Insbesondere kann die Vergrößerung der Auflösung derart erfolgen, dass im finalen Magnetresonanzbilddatensatz, der mit dem zweiten Sichtfeldparametersatz aufgenommen wird, die gleiche effektive Auflösung erhalten wird, die auch bezüglich des ursprünglichen Sichtfelds erwartet war.

Neben dem Verfahren betrifft die Erfindung auch eine Magnetresonanzeinrichtung, welche eine Gradientenspulenanordnung zur Erzeugung von bei der Magnetresonanzaufnahme zur Ortskodierung zu verwendenden Gradientenfelder und eine Steuereinrichtung aufweist, wobei die Steuereinrichtung zur Verzerrungskorrektur aufgenommener Magnetresonanzdatensätze zumindest für durch Imperfektionen der Gradientenfelder verursachte Verzerrungen anhand einer Verzerrungskarte ausgebildet ist, wobei die Steuereinrichtung zur Durchführung des erfindungsgemäßen Verfahrens ausgebildet ist. Sämtliche Ausführungen bezüglich des erfindungsgemäßen Verfahrens lassen sich analog auf die erfindungsgemäße Magnetresonanzeinrichtung übertragen, so dass auch mit dieser die bereits genannten Vorteile erhalten werden können.

Die Steuereinrichtung kann insbesondere wenigstens einen Prozessor und wenigstens ein Speichermittel aufweisen. Durch Hardware und/oder Software können Funktionseinheiten realisiert werden, um verschiedene Schritte des erfindungsgemäßen Verfahrens durchführen zu können. Insbesondere kann die Steuereinrichtung eine Ermittlungseinheit für die Ausschlussinformation, eine Bestimmungseinheit für den zweiten Satz von Sichtfeldparametern und eine Sequenzeinheit zur Steuerung der Magnetresonanzaufnahme an sich, insbesondere auch unter Verwendung des zweiten Satzes von Sichtfeldparametern, umfassen.

Ein erfindungsgemäßes Computerprogramm ist direkt in ein Speichermittel einer Steuereinrichtung einer Magnetresonanzeinrichtung ladbar und weist Programmmittel auf, um die Schritte eines erfindungsgemäßen Verfahrens durchzuführen, wenn das Computerprogramm auf der Steuereinrichtung ausgeführt wird. Das Computerprogramm kann auf einem elektronisch lesbaren Datenträger gemäß der vorliegenden Erfindung gespeichert sein, welcher mithin darauf gespeicherte elektronisch lesbare Steuerinformationen umfasst, die wenigstens ein erfindungsgemäßes Computerprogramm umfassen und bei Verwendung des Datenträgers in einer Steuereinrichtung einer Magnetresonanzeinrichtung diese ansteuern, die Schritte eines erfindungsgemäßen Verfahrens durchzuführen. Bei dem elektronisch lesbaren Datenträger kann es sich insbesondere um einen nichttransienten Datenträger, beispielsweise eine CD-ROM, handeln.

Weitere Vorteile und Einzelheiten der vorliegenden Erfindung ergeben sich aus den im Folgenden beschriebenen Ausführungsbeispielen sowie anhand der Zeichnungen. Dabei zeigen:
- Fig. 1: eine erste schematische Skizze zur Erläuterung nicht abgebildeter Bereiche,
- Fig. 2: eine zweite schematische Skizze zur Erläuterung nicht abgebildeter Bereiche,
- Fig. 3: einen Ablaufplan eines ersten Ausführungsbeispiels des erfindungsgemäßen Verfahrens,
- Fig. 4: eine erste mögliche Anzeige in einer Benutzeroberfläche,
- Fig. 5: eine zweite mögliche Anzeige in einer Benutzeroberfläche,
- Fig. 6: einen Ablaufplan eines zweiten Ausführungsbeispiels des erfindungsgemäßen Verfahrens,
- Fig. 7: ein ermitteltes Maskenbild in einem ursprünglichen Sichtfeld,
- Fig. 8: eine Skizze zur Ermittlung eines erweiterten Sichtfelds,
- Fig. 9: eine erfindungsgemäße Magnetresonanzeinrichtung, und
- Fig. 10: den funktionalen Aufbau einer Steuereinrichtung der Magnetresonanzeinrichtung.

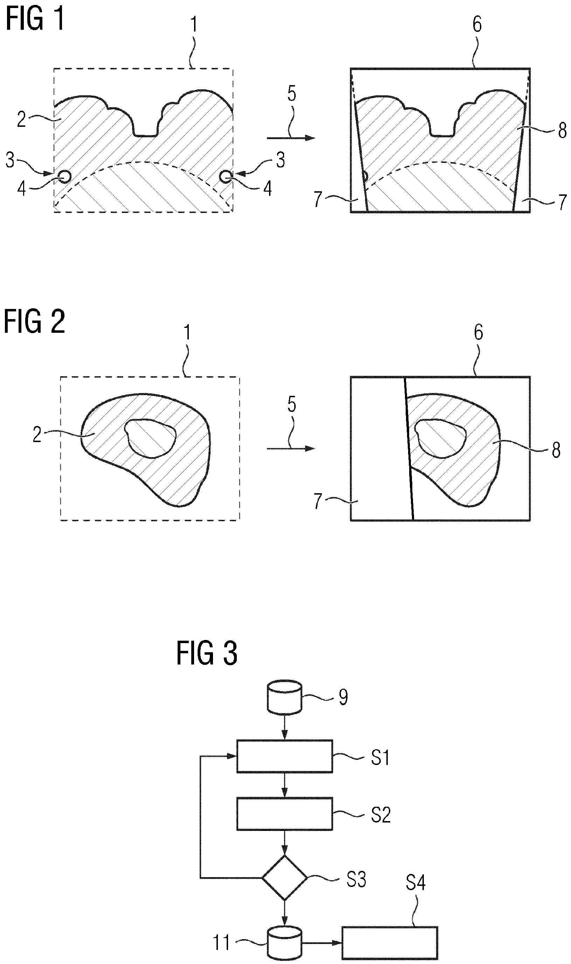

Die Figuren 1 und 2 erläutern als Prinzipskizze das der vorliegenden Erfindung zugrunde liegende Problem. Fig. 1 zeigt beispielhaft ein für eine Brustuntersuchung gewähltes Sichtfeld 1 mit einer angedeuteten, aufzunehmenden Anatomie 2, welche als zu zeigende Merkmale 3 gemäß einer Untersuchungsinformation auch die randseitig gelegenen, hier schematisch hervorgehobenen Lymphknoten 4 umfasst. Erfolgt gemäß dem Pfeil 5 eine Magnetresonanzaufnahme mit diesem Sichtfeld 1, genauer mit entsprechenden Sichtfeldparametern, so erhält man nach der Verzerrungskorrektur unter Nutzung einer Verzerrungskarte, die durch Verzerrungskoeffizienten Ortsverschiebungen beschreibt, ein Magnetresonanzdatensatz 6, für den innerhalb des Sichtfelds 1 in einem nicht abgebildeten Bereich 7 keine Bilddaten vorliegen. Dieser nicht abgebildete Bereich 7 umfasst im vorliegenden Beispiel unglücklicherweise auch zumindest teilweise die Lymphknoten 4. Anders ausgedrückt wurden scheinbar von Positionen innerhalb des nicht abgebildeten Bereichs 7 stammende Magnetresonanzsignale im Rahmen der Verzerrungskorrektur bildpunktweise an ihre tatsächlichen Positionen verschoben, wobei aufgrund der Imperfektionen der Gradientenfelder keine Magnetresonanzdaten vorlagen, die in den nicht abgebildeten Bereich 7 zu verschieben wären.

Fig. 2 zeigt ein entsprechendes weiteres Beispiel, in dem als Anatomie 2 ein Arm aufgenommen werden sollte, wobei ersichtlich im dortigen Magnetresonanzdatensatz 6, aufgrund der randseitigen Befindlichkeit des Armes im Homogenitätsvolumen, ein sehr großer Anteil nicht abgebildet ist, also zum nicht abgebildeten Bereich 7 gehört. In solchen Fällen kann es vorkommen, dass nicht jede benötigte Information im entsprechend abgebildeten Bereich 8 enthalten ist.

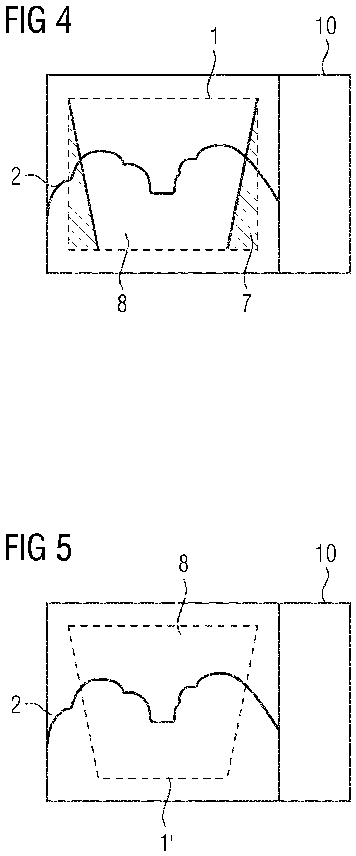

Fig. 3 zeigt einen Ablaufplan eines ersten Ausführungsbeispiels eines erfindungsgemäßen Verfahrens. Dabei wird ausgegangen von einem ersten Satz 9 von Sichtfeldparametern, die ein ursprüngliches Sichtfeld 1 beschreiben, das beispielsweise durch einen Benutzer ausgewählt und/oder vorgegeben sein kann. Im vorliegenden Fall wünscht der Benutzer selbst mittels einer Benutzeroberfläche, die auf einer Anzeigeeinrichtung dargestellt wird, ein geeignetes Sichtfeld 1 für die folgende Magnetresonanzaufnahme eines Patienten einzustellen. Mithin entspricht der erste Satz 9 von Sichtfeldparametern insbesondere einem aktuell in dem Benutzerinterface dargestellten, ursprünglichen Sichtfeld 1, wobei eine entsprechende Benutzeroberfläche 9 schematisch in Fig. 4 angedeutet ist. Dort ist in einem Teilbereich die Anatomie 2 des Patienten, beispielsweise aus einer Localizer-Aufnahme bzw. einem sonstigen vorab aufgenommenen Magnetresonanzdatensatz, dargestellt, der bezüglich auch das aktuell eingestellte Sichtfeld 1 mit dem aktuellen, ersten Satz 9 von Sichtfeldparametern visualisiert wird.

Gemäß dem Verfahren der Fig. 3 wird in einem Schritt S1 unter Verwendung der in einem Speichermittel der Steuereinrichtung der Magnetresonanzeinrichtung abgelegten Verzerrungskarte der nicht abgebildete Bereich 7 bereits vor Beginn der Magnetresonanzaufnahme ermittelt. Dies kann zum einen durch Anwendung der Verzerrungskarte, also der üblichen Verzerrungskorrektur, auf jeden Bildpunkt des ursprünglichen Sichtfelds 1 erfolgen, so dass sichtbar wird, aus welchen Anteilen des Sichtfelds 1 Bildpunkte herausgeschoben werden, ohne dass sonstige Bildinformation vorliegt. Denkbar ist es jedoch auch, eine inverse Verzerrungskorrektur auf das ursprüngliche Sichtfeld 1 anzuwenden und dabei zu überwachen, welche Bildpunkte des ursprünglichen Sichtfelds 1 aus diesem heraus verschoben werden, woraus gefolgert werden kann, dass diese Bildpunkte zu dem nicht abgebildeten Bereich 7 gehören. In jedem Fall liegt zum Abschluss des Schrittes S1 eine Ausschlussinformation vor, die die Aufteilung des Sichtfelds 1 in den nicht abgebildeten Bereich 7 und den abgebildeten Bereich 8 beschreibt.

In einem Schritt S2 wird die Ausschlussinformation zur Unterstützung des Benutzers in der Benutzeroberfläche 10 visualisiert. Hierzu existieren zwei konkrete Ansätze, die auch in Kombination verwendet werden können und die in den Fig. 4 und 5 schematisch dargestellt sind. Gemäß der Fig. 4 wird der nicht abgebildete Bereich 7 gemäß der Ausschlussinformation selbst angezeigt, beispielsweise durch farbliche Überlagerung oder Einfärbung, wie durch die Schraffur in Fig. 4 angedeutet ist. Der Benutzer kann mithin unmittelbar erkennen, wo innerhalb des Sichtfelds 1 nicht abgebildete Anteile liegen. Gemäß der Option nach Fig. 5 wird die Anzeige des Sichtfelds 1 selbst modifiziert, indem eine angepasste Begrenzung 1' dargestellt wird, die nur den abgebildeten Bereich 8 gemäß der Ausschlussinformation umschließt. In diesem Fall wird also von der üblichen rechtwinkligen Sichtfeldbegrenzung abgegangen und diese zur Visualisierung nicht dargestellter Bereiche 7, hier indirekt, modifiziert. Dabei sei an dieser Stelle noch angemerkt, dass für das ursprüngliche Sichtfeld 1 grundsätzlich von einem wie bekannt rechteckigen bzw. quaderförmigen Sichtfeld 1 ausgegangen wird.

In einem Schritt S3 gemäß Fig. 3 wird dann überprüft, ob aufgrund einer Benutzereingabe Änderungen des einzustellenden Sichtfelds 1 vorgenommen wurden oder ob das aktuell einzustellende Sichtfeld 1 akzeptiert wird und somit der aktuelle erste Satz 9 von Sichtfeldparametern als zweiter Satz 11 von Sichtfeldparametern für die im Schritt S4 erfolgende Magnetresonanzaufnahme durch den Benutzer bestätigt wurde. Im Falle einer Änderung des einzustellenden Sichtfelds 1 wird der geänderte Satz von Sichtfeldparametern als neuer erster Satz 9 von Sichtfeldparametern gesetzt und wieder zu Schritt S1 zurückgekehrt, so dass auch vollständig automatisch eine Aktualisierung der Anzeige in der Benutzeroberfläche 10 erfolgt.

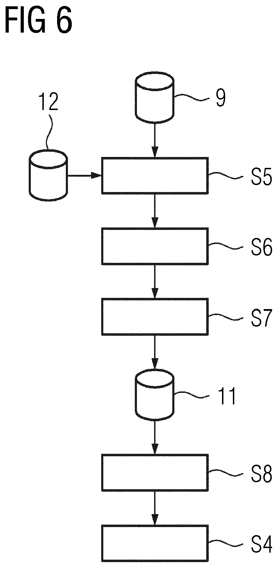

Fig. 6 illustriert ein zweites Ausführungsbeispiel des erfindungsgemäßen Verfahrens. Dabei sei angemerkt, dass das erste und das zweite Ausführungsbeispiel zumindest teilweise auch kombiniert werden können, beispielsweise indem eine benutzerseitige Einstellung mittels der Benutzeroberfläche 10 zum ersten Satz 9 führt, der dann automatisch verbessert wird, oder indem eine benutzerseitige Anpassung an eine automatische Bestimmung eines Vorschlags für einen zweiten Satz 11 anschließt; schließlich ist es selbstverständlich auch denkbar, beide Vorgehensweisen (benutzerseitig durch Realisierung unterstützter Einstellung/automatische Ermittlung eines Vorschlags) in der Steuereinrichtung zur Auswahl anzubieten.

Auch im zweiten Ausführungsbeispiel des erfindungsgemäßen Verfahrens wird von einem ersten Satz 9 von Sichtfeldparametern, die ein ursprüngliches Sichtfeld 1 beschreiben, ausgegangen. Bei diesem kann es sich insbesondere auch um ein benutztes Sichtfeld einer vorherigen Magnetresonanzaufnahme handeln, für welche ein Aktionskriterium erfüllt ist, wonach zu zeigende Merkmale nicht abgebildet sind bzw. ein zu großer Anteil nicht abgebildet ist.

Aus diesem ersten Satz 9 soll nun unter Nutzung der Ausschlussinformation ein zweiter Satz 11 von Sichtfeldparametern ermittelt werden, dessen zugehöriges Sichtfeld hinsichtlich auftretender Verzerrungen und nicht abgebildeter Bereiche 7 verbessert ist. Dabei ist es zwar grundsätzlich denkbar, den zweiten Satz 11 von Sichtfeldparametern derart zu bestimmen, dass das gesamte ursprüngliche Sichtfeld 1 in dem zugehörigen neuen Sichtfeld enthalten ist. Eine bevorzugte Ausgestaltung kann sich in der Beurteilung auf nicht dargestellte Anteile des beispielsweise in dem Localizer-Bild bzw. dem vorher aufgenommenen Magnetresonanzdatensatz segmentierbaren Patienten beschränken, nachdem nicht abgebildete Luft-Bildpunkte oder Umgebungs-Bildpunkte des ursprünglichen Sichtfelds als irrelevant bewertet werden können. In der am meisten bevorzugten Ausführungsform wird jedoch eine Untersuchungsinformation 12 bereitgestellt, die in der vorzunehmenden Magnetresonanzaufnahme zu zeigende Merkmale 3, insbesondere also anatomische Merkmale, beschreibt. Dennoch sei angemerkt, dass die Untersuchungsinformation 12 in Fig. 6 selbstverständlich auch allgemein den Patienten als zu zeigendes Merkmal 3 nennen kann.

Die Untersuchungsinformation 12 wird in einem Schritt S5 genutzt, um ein Maskenbild für das ursprüngliche Sichtfeld 1, beschrieben durch die Sichtfeldparameter des ersten Satzes 9, zu ermitteln. Das Maskenbild kann bevorzugt ein binäres Bild sein, welches für zu zeigende Merkmale 3, die beispielsweise in dem Localizer-Bild und/oder dem zuvor aufgenommenen Magnetresonanzbilddatensatz segmentiert werden können, insbesondere auch unter Zuhilfenahme eines anatomischen Atlanten, so dass eine einfache Abfrage für innerhalb des ursprünglichen Sichtfelds 1 (in seiner Form ohne Berücksichtigung von Verzerrungen, also insbesondere Rechteckform oder Quaderform) liegende Bildpunkte erfolgen kann, ob der Bildpunkt gemäß der Segmentierung zu einem zu zeigenden Merkmal 3 gehört oder nicht. Dabei können auch, um Ungenauigkeiten der Segmentierung und dergleichen abzudecken, Segmentierungsergebnisse um einen Toleranzbereich erweitert werden. Gehört ein Bildpunkt zu einem zu zeigenden Merkmal 3, welches wie gesagt auch die gesamte Anatomie 2 sein kann, erhält der entsprechende Bildpunkt des Maskenbildes den Wert "1", ansonsten den Wert "0". Der Wert "1" beschreibt relevante Anteile des Sichtfelds 1, der Wert "0" irrelevante Anteile des Sichtfelds 1.

In einem Schritt S6 wird nun wiederum eine Ausschlussinformation bestimmt, in diesem Fall jedoch durch Anwendung der inversen Verzerrungskorrektur auf das Maskenbild, wobei insbesondere bereits an dieser Stelle lediglich noch die relevanten Anteile berücksichtigt werden können. In jedem Fall werden für die Ermittlung der nicht abgebildeten Bereiche 7 dann lediglich relevante Bildpunkte gemäß Maskenbild herangezogen.

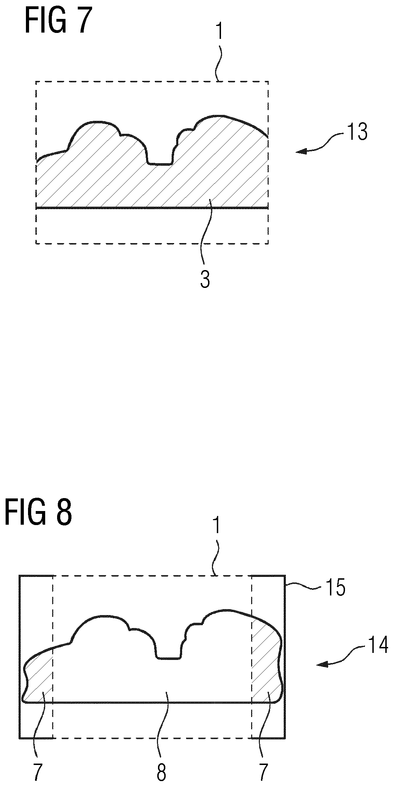

Dies wird gemäß der Figuren 7 und 8 schematisch genauer erläutert. Fig. 7 zeigt schematisch ein gemäß Schritt S5 innerhalb des ursprünglichen Sichtfelds 1 ermitteltes Maskenbild 13 für ein zu zeigendes Merkmal 3. Das Maskenbild 13 wurde binär entwickelt, hat also in Bildpunkten, in denen das zu zeigende Merkmal 3 vorliegt, den Wert "1", ansonsten den Wert "0". Es sei angemerkt, dass selbstverständlich auch, beispielsweise je nach Art der Segmentierungsergebnisse, mit Werten zwischen 0 und 1 im Sinne einer Wahrscheinlichkeit, dass das zu zeigende Merkmal 3 in dem Bildpunkt vorliegt, gearbeitet werden kann, wobei dann zweckmäßigerweise zur Unterscheidung zwischen relevanten und nicht relevanten Bildpunkten ein Schwellwert verwendet werden kann.

Fig. 8 zeigt nun das mit der inversen Verzerrungskorrektur, also den umgekehrten räumlichen Verschiebungen im Vergleich zur Verzerrungskarte, behandelte Maskenbild 13, mithin das Ergebnisbild 14. Ersichtlich sind relevante Bildpunkte aus dem ursprünglichen Sichtfeld 1 herausbewegt worden, so dass sie zum nicht abgebildeten Bereich 7 zählen. Dies ermöglicht es auf einfache Weise, in einem Schritt S7 gemäß Fig. 6 einen zweiten Satz 11 von Sichtfeldparametern derart zu bestimmen, dass das zugehörige Sichtfeld 15 die verschobenen Bildpunkte des zu zeigenden Merkmals 3, also den nicht abgebildeten Bereich 7, gerade enthält, beispielsweise als kleinstes, sowohl den abgebildeten Bereich 8 als auch den nicht abgebildeten Bereich 7 in der wenigstens einen relevanten Dimension, wo nicht abgebildete Randbereiche vorliegen, umfassende Rechteck bzw. Quader. Dies ist in Fig. 8 schematisch dargestellt.

In einem Schritt S8 kann das dem zweiten Satz 11 von Sichtfeldparametern entsprechende neue Sichtfeld 15 dem Benutzer als Vorschlag präsentiert werden, den dieser bestätigen kann. Wird die Bestätigung erhalten, erfolgt im Schritt S4 die Magnetresonanzaufnahme mit dem zweiten Satz 11 von Sichtfeldparametern.

Es sei an dieser Stelle noch angemerkt, dass die Untersuchungsinformation 12 in Ausführungsbeispielen auch genutzt werden kann, um den ersten Satz 9 von Sichtfeldparametern automatisch zu ermitteln bzw. vorzugeben. Beispielsweise kann zunächst ein ursprüngliches Sichtfeld 1 derart ermittelt werden, dass es durch die Untersuchungsinformation 12 vorgegebene, zu zeigende Merkmale 3 als Rechteck oder Quader enthält, wonach dann basierend hierauf die Schritte S5 bis S8 und S4 folgen können.

Es kann auch vorgesehen sein, bei Vergrößerung des durch den zweiten Satz 11 von Sichtfeldparametern beschriebenen Sichtfelds 15 gegenüber dem ursprünglichen Sichtfeld 1 die Auflösung zu erhöhen. Zwar ist es grundsätzlich denkbar, die gleiche Auflösung beizubehalten, jedoch zweckmäßiger, die Auflösung entsprechend zu vergrößern, so dass der Benutzer den erwarteten Bildeindruck auch trotz des vergrößerten Sichtfelds 15 erhalten kann. Insbesondere kann die Vergrößerung der Auflösung derart erfolgen, dass im finalen Magnetresonanzbilddatensatz, der mit dem zweiten Satz 11 von Sichtfeldparametern aufgenommen wird, die gleiche effektive Auflösung erhalten wird, die auch bezüglich des ursprünglichen Sichtfelds 1 erwartet war.

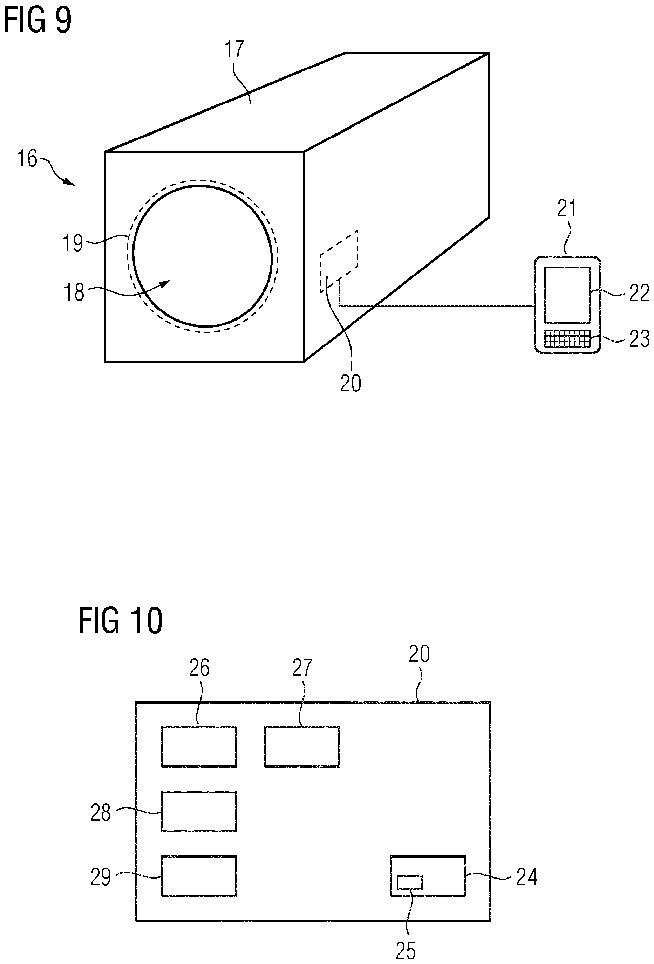

Fig. 9 zeigt schematisch ein Ausführungsbeispiel einer erfindungsgemäßen Magnetresonanzeinrichtung 16. Diese umfasst, wie grundsätzlich bekannt, ein Hauptmagneteinheit 17 mit dem Hauptmagneten zur Erzeugung des Grundmagnetfelds, wobei die Hauptmagneteinheit 17 eine zylindrische Patientenaufnahme 18 aufweist, in die der Patient mittels einer hier nicht näher dargestellten Patientenliege eingefahren werden kann. Die Patientenaufnahme 18 umgebend sind eine hier nicht näher gezeigte Hochfrequenzspulenanordnung und eine Gradientenspulenanordnung 19 vorgesehen.

Der Betrieb der Magnetresonanzeinrichtung 16 wird von einer Steuereinrichtung 20 gesteuert, der auch eine Bedieneinrichtung 21 mit einer Anzeigeeinrichtung 22 und einer Eingabeeinrichtung 23 zugeordnet ist. Die Steuereinrichtung 20 umfasst wenigstens einen Prozessor und wenigstens ein Speichermittel. Nachdem Imperfektionen der Gradientenfelder der Gradientenspulenanordnung 19 existieren können, ist in dem Speichermittel als Verzerrungsinformation eine Verzerrungskarte abgelegt, wobei die Steuereinrichtung 20 ausgebildet ist, aufgenommene Magnetresonanzdatensätze hinsichtlich der durch die Imperfektionen der Gradientenfelder entstehenden Verzerrungen mittels der Verzerrungskarte zu korrigieren. Es sei angemerkt, dass, auch wenn dies nicht explizit bezüglich der Verfahren beschrieben wurde, selbstverständlich auch für den im Schritt S4 aufgenommenen Magnetresonanzdatensatz bzw. allgemein für mit dem zweiten Satz 11 von Sichtfeldparametern aufgenommene Magnetresonanzdatensätze eine Verzerrungskorrektur mit der Verzerrungskarte erfolgt.

Fig. 10 zeigt die funktionale Struktur der Steuereinrichtung 20 genauer. Wie bereits erwähnt, weist diese das Speichermittel 24 auf, in welchem beispielsweise bereits die Verzerrungskarte 25 gespeichert ist, die selbstverständlich aber auch andere für und während des erfindungsgemäßen Verfahrens, zu dessen Durchführung die Steuereinrichtung 20 ausgebildet ist, anfallende Daten genutzt werden kann, beispielsweise Sätze 9, 11 von Sichtfeldparametern, Untersuchungsinformationen 12, Maskenbilder 13 und dergleichen.

Die Steuereinrichtung 20 umfasst als Funktionseinheiten zunächst eine grundsätzlich bekannte Frequenzeinheit 26 zur Steuerung der Magnetresonanzaufnahmen, auch im Schritt S4, sowie eine Benutzerinteraktionseinheit 27 zur Benutzerinteraktion mittels der Bedieneinrichtung 21. Insbesondere kann die Interaktionseinheit 27 auch zur wenigstens teilweisen Durchführung der Schritte S3 und S8 ausgebildet sein.

In einer Ermittlungseinheit 28 kann die Ausschlussinformation ermittelt werden, vgl. hierzu Schritte S1 und S6. In einer Bestimmungseinheit 29 kann dann die Bestimmung des zweiten Satzes 11 von Sichtfeldparametern, gegebenenfalls unter Mitwirkung der Interaktionseinheit 27, stattfinden, vgl. insbesondere auch zur automatischen Ermittlung den Schritt S7. Es sei angemerkt, dass der Schritt S2 wenigstens teilweise auch durch die Interaktionseinheit 27 umgesetzt wird.

Obwohl die Erfindung im Detail durch das bevorzugte Ausführungsbeispiel näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung zu verlassen.

## Patentansprüche

1. Computerimplementiertes Verfahren zur Einstellung eines Sichtfelds für eine Magnetresonanzaufnahme, insbesondere eines Patienten, mit einer Magnetresonanzeinrichtung (16), welche eine Gradientenspulenanordnung (19) zur Erzeugung von bei der Magnetresonanzaufnahme zur Ortskodierung zu verwendenden Gradientenfeldern und eine Steuereinrichtung (20) aufweist, wobei die Steuereinrichtung (20) zur Verzerrungskorrektur aufgenommener Magnetresonanzdatensätze zumindest für durch Imperfektionen der Gradientenfelder verursachte Verzerrungen anhand einer Verzerrungskarte (25) ausgebildet ist, wobei durch die Steuereinrichtung (20)
- auf Basis der Verzerrungskarte (25) für wenigstens einen ersten Satz (9) von ein rechteckiges oder quaderförmiges, ursprüngliches Sichtfeld (1) beschreibenden Sichtfeldparametern eine einen aufgrund der Verzerrung nicht abgebildeten Bereich (7) des ursprünglichen Sichtfelds (1) beschreibende Ausschlussinformation ermittelt wird,
- unter Verwendung der Ausschlussinformation ein zweiter, für die Magnetresonanzaufnahme zu nutzender Satz (11) von Sichtfeldparametern bestimmt wird, und
- die Magnetresonanzaufnahme unter Verwendung des zweiten Satzes (11) von Sichtfeldparametern erfolgt,
**dadurch gekennzeichnet, dass** das ursprüngliche, einzustellende Sichtfeld (1) in einer Benutzeroberfläche (10), insbesondere gemeinsam mit einer Anatomie (2) des aufzunehmenden Patienten, auf einer Anzeigeeinrichtung (22) angezeigt wird, wobei die Ausschlussinformation zur Anzeige des nicht abgebildeten Bereichs (7) gemäß der Ausschlussinformation und/oder zur Anpassung der Begrenzung (1') der Sichtfeldanzeige zum Ausschluss des nicht abgebildeten Bereichs (7) verwendet wird, wobei bei einer Änderung des einzustellenden Sichtfelds (1) aufgrund einer Benutzereingabe die das veränderte einzustellende Sichtfeld (1) beschreibenden Sichtfeldparameter als neuer erster Satz (9) zur Aktualisierung der Ausschlussinformation verwendet werden, woraufhin der nicht abgebildete Bereich (7) aufgrund der aktualisierten Ausschlussinformation für das veränderte einzustellende Sichtfeld (1) angezeigt wird.

2. Verfahren nach Anspruch 1, **dadurch gekennzeichnet, dass** die Ermittlung des zweiten Satzes (11) von Sichtfeldparametern basierend auf einer benutzerseitigen Auswahl eines Sichtfelds (1, 15) erfolgt, bei einer Anzeige gemäß Anspruch 1 insbesondere als das ausgewählte Sichtfeld.

3. Verfahren nach Anspruch 2, **dadurch gekennzeichnet, dass** basierend auf einer benutzerseitigen Wahl des ursprünglichen Sichtfelds (1) durch die Steuereinrichtung (20) automatisch ein zweiter Satz (11) von Sichtfeldparametern derart ermittelt wird, dass der dargestellte Bereich (8) des zugehörigen Sichtfelds (15) das gesamte ausgewählte, ursprüngliche Sichtfeld (1) umfasst.

4. Verfahren nach Anspruch 3, **dadurch gekennzeichnet, dass** eine schrittweise Vergrößerung ausgehend von dem ausgewählten, ursprünglichen Sichtfeld (1) in zumindest einer Dimension, in der am Rand nicht abgebildeter Bereich (7) vorliegt, zur Auswahl von zu überprüfenden ersten Sichtparametersätzen (9) erfolgt, bis ein geeigneter zweiter Satz (11) von Sichtfeldparametern aufgefunden wird, oder dass die Ermittlung des nicht abgebildeten Bereichs (7) durch Anwendung der inversen Verzerrungskorrektur gemäß der Verzerrungskarte (25) auf das ursprüngliche Sichtfeld (1) erfolgt und der zweite Satz (11) von Sichtfeldparametern so gewählt wird, dass das zugehörige Sichtfeld (15) das Anwendungsergebnis vollständig umfasst.

5. Verfahren nach einem der vorangehenden Ansprüche, **dadurch gekennzeichnet, dass** basierend auf einer in der Magnetresonanzaufnahme zu zeigende Merkmale (3), insbesondere anatomische Merkmale (3), beschreibenden Untersuchungsinformation (12) durch die Steuereinrichtung (20) automatisch, ausgehend von einem ursprünglichen, diese Merkmale (3) ohne Berücksichtigung der Verzerrung enthaltenden und/oder benutzerseitig ausgewählten Sichtfeld (1) überprüft wird, ob der abgebildete Bereich (8) dieses ursprünglichen Sichtfelds (1) alle zu zeigenden Merkmale (3) umfasst, wobei bei nicht alle zu zeigenden Merkmale (3) umfassendem abgebildeten Bereich (8)
- automatisch ein zweiter Satz (11) von Sichtfeldparametern derart ermittelt wird, dass der abgebildete Bereich (8) des zugehörigen Sichtfelds (15) alle zu zeigenden Merkmale (3) umfasst, und/oder
- ein Warnhinweis an den Benutzer ausgegeben wird.

6. Verfahren nach einem der vorangehenden Ansprüche, **dadurch gekennzeichnet, dass** der erste Satz (9) von Sichtparametern ein genutztes, ursprüngliches Sichtfeld (1) einer bereits erfolgten Magnetresonanzaufnahme beschreibt, wobei durch die Steuereinrichtung (20) automatisch ein Aktionskriterium ausgewertet wird, das überprüft, ob der Anteil des nicht abgebildeten Bereichs (7) an dem genutzten Sichtfeld (1) ohne Berücksichtigung der Verzerrung einen Schwellwert überschreitet und/oder wenigstens ein gemäß einer oder der Untersuchungsinformation (12) in der Magnetresonanzaufnahme zu zeigendes Merkmal (3) wenigstens teilweise in dem nicht abgebildeten Bereich (7) liegt, wobei bei Erfüllung des Aktionskriteriums automatisch ein für eine noch zu erfolgende Magnetresonanzaufnahme zu verwendender zweiter Satz (11) von Sichtfeldparametern derart ermittelt wird, dass der Anteil des nicht abgebildeten Bereichs (7) an dem genutzten, ursprünglichen Sichtfeld (1) ohne Berücksichtigung der Verzerrung einen weiteren oder den Schwellwert unterschreitet und/oder der abgebildete Bereich (8) des dem zweiten Satz (11) von Sichtfeldparametern zugehörigen Sichtfelds (15) alle zu zeigenden Merkmale (3) umfasst.

7. Verfahren nach einem der vorangehenden Ansprüche, **dadurch gekennzeichnet, dass** die Ermittlung des nicht abgebildeten Bereichs (7) durch Anwendung der inversen Verzerrungskorrektur gemäß der Verzerrungskarte (25) auf ein Maskenbild (13) des ursprünglichen Sichtfelds (1) zur Ermittlung eines Ergebnisbildes (14) erfolgt, wobei die außerhalb des ursprünglichen Sichtfelds (1) ohne Berücksichtigung der Verzerrung liegenden Anteile des Ergebnisbildes (14) als nicht abgebildeter Bereich (7) identifiziert werden.

8. Verfahren nach Anspruch 7, **dadurch gekennzeichnet, dass** das Maskenbild (13) auf Basis eines Modells und/oder einer bereits erfolgten Magnetresonanzaufnahme derart bestimmt wird, dass es anzeigt, wo im ursprünglichen Sichtfeld (1) ohne Berücksichtigung der Verzerrung, insbesondere aufzunehmende, Anteile, insbesondere zu zeigende Merkmale (3), des Patienten vorliegen, wobei zur Ermittlung des nicht abgebildeten Bereichs (7) nur aufzunehmende Anteile des Patienten gemäß dem Maskenbild (13) berücksichtigt werden.

9. Verfahren nach Anspruch 7 oder 8, **dadurch gekennzeichnet, dass** automatisch ein zweiter Satz (11) von Sichtfeldparametern bestimmt wird, indem ausgehend von dem ursprünglichen Sichtfeld (1) ein erweitertes Sichtfeld (15) derart bestimmt wird, dass es den nicht abgebildeten Bereich (7) umfasst.

10. Verfahren nach einem der vorangehenden Ansprüche, **dadurch gekennzeichnet, dass** bei Vergrößerung des durch den zweiten Satz (11) von Sichtfeldparametern beschriebenen Sichtfelds (15) gegenüber dem ursprünglichen Sichtfeld (1) die Auflösung erhöht wird, insbesondere entsprechend dem Grad der Vergrößerung.

11. Magnetresonanzeinrichtung (16), welche eine Gradientenspulenanordnung (19) zur Erzeugung von bei der Magnetresonanzaufnahme zur Ortskodierung zu verwendenden Gradientenfeldern und eine Steuereinrichtung (20) aufweist, wobei die Steuereinrichtung (20) zur Verzerrungskorrektur aufgenommener Magnetresonanzdatensätze zumindest für durch Imperfektionen der Gradientenfelder verursachte Verzerrungen anhand einer Verzerrungskarte (25) ausgebildet ist, **dadurch gekennzeichnet, dass** die Steuereinrichtung (20) zur Durchführung eines Verfahrens nach einem der vorangehenden Ansprüche ausgebildet ist.

12. Computerprogramm, welches die Schritte eines Verfahrens nach einem der Ansprüche 1 bis 10 durchführt, wenn es auf einer Steuereinrichtung (20) einer Magnetresonanzeinrichtung (16) ausgeführt wird.

13. Elektronisch lesbarer Datenträger, auf dem ein Computerprogramm nach Anspruch 12 gespeichert ist.

## Claims

1. Computer-implemented method for setting a field of view for a magnetic resonance scan, in particular of a patient, with a magnetic resonance facility (16), which has a gradient coil arrangement (19) for generating gradient fields to be used during the magnetic resonance scan for spatial encoding, and a control facility (20), wherein the control facility (20) is designed for distortion correction on the basis of a distortion map (25) of acquired magnetic resonance data sets at least for distortions caused by imperfections of the gradient fields, wherein by way of the control facility (20)
- exclusion information describing a region (7) of the original field of view (1) that is unmapped owing to the distortion is ascertained on the basis of the distortion map (25) for at least one first set (9) of field of view parameters describing a rectangular or cuboidal original field of view (1),
- using the exclusion information a second set (11) of field of view parameters to be used for the magnetic resonance scan is determined, and
- the magnetic resonance scan takes place using the second set (11) of field of view parameters,
**characterised in that** the original field of view (1) to be set in a user interface (10), in particular together with an anatomy (2) of the patient to be scanned, is displayed on a display facility (22), wherein the exclusion information is used for displaying the unmapped region (7) in accordance with the exclusion information and/or for adjusting the limitation (1') of the field of view display for exclusion of the unmapped region (7), wherein with a change in the field of view (1) to be set owing to a user input, the field of view parameters describing the changed field of view (1) to be set are used as a new first set (9) for updating the exclusion information, whereupon the unmapped region (7) owing to the updated exclusion information is displayed for the changed field of view (1) to be set.

2. Method according to claim 1, **characterised in that** the second set (11) of field of view parameters is ascertained on the basis of a user selection of a field of view (1, 15) during a display according to claim 1, in particular as the selected field of view.

3. Method according to claim 2, **characterised in that** based on a user selection of the original field of view (1) by the control facility (20), a second set (11) of field of view parameters is automatically ascertained in such a way that the represented region (8) of the associated field of view (15) comprises the entire selected, original field of view (1).

4. Method according to claim 3, **characterised in that** a gradual enlargement starting from the selected, original field of view (1) takes place in at least one dimension, in which an unmapped region (7) is present at the edge, for selection of first view parameter sets (9) to be checked until a suitable second set (11) of field of view parameters is found, or that the unmapped region (7) is ascertained by application of the inverse distortion correction in accordance with the distortion map (25) to the original field of view (1) and the second set (11) of field of view parameters is selected such that the associated field of view (15) completely comprises the application result.

5. Method according to one of the preceding claims, **characterised in that** based on examination information (12) describing features (3), in particular anatomical features (3), to be shown in the magnetic resonance scan, the control facility (20), starting from an original field of view (1) containing these features (3) without taking into account the distortion and/or selected by the user, automatically checks whether the mapped region (8) of this original field of view (1) comprises all features (3) to be shown, wherein in the case of the mapped region (8) that does not comprise all features (3) to be shown
- a second set (11) of field of view parameters is automatically ascertained in such a way that the mapped region (8) of the associated field of view (15) comprises all features (3) to be shown, and/or
- a warning is output to the user.

6. Method according to one of the preceding claims, **characterised in that** the first set (9) of view parameters describes a used, original field of view (1) of a magnetic resonance scan that has already taken place, wherein the control facility (20) automatically evaluates an action criterion, which checks whether the portion of the unmapped region (7) of the used field of view (1), without taking into account the distortion, overshoots a threshold value and/or at least one feature (3) to be shown in the magnetic resonance scan in accordance with an item of or the examination information (12) is located at least partially in the unmapped region (7), wherein when the action criterion is met, a second set (11) of field of view parameters to be used for a magnetic resonance scan yet to take place is automatically ascertained in such a way that the portion of the unmapped region (7) of the used, original field of view (1), without taking into account the distortion, undershoots a further or the threshold value and/or the mapped region (8) of the field of view (15) associated with the second set (11) of field of view parameters comprises all features (3) to be shown.

7. Method according to one of the preceding claims, **characterised in that** the unmapped region (7) is ascertained by application of the inverse distortion correction in accordance with the distortion map (25) to a mask image (13) of the original field of view (1) for ascertaining a resulting image (14), wherein the portions of the resulting image (14) located outside of the original field of view (1), without taking into account the distortion, are identified as an unmapped region (7).

8. Method according to claim 7, **characterised in that** the mask image (13) is determined on the basis of a model and/or a magnetic resonance scan that has already taken place in such a way that it displays where in the original field of view (1), without taking into account the distortion, in particular portions of the patient to be scanned, in particular features (3) to be shown, are present, wherein for ascertaining the unmapped region (7) only portions of the patient to be scanned in accordance with the mask image (13) are taken into account.

9. Method according to claim 7 or 8, **characterised in that** a second set (11) of field of view parameters is automatically determined, **in that** starting from the original field of view (1), an expanded field of view (15) is determined in such a way that it comprises the unmapped region (7).

10. Method according to one of the preceding claims, **characterised in that** with enlargement of the field of view (15) described by the second set (11) of field of view parameters compared with the original field of view (1), the resolution is increased, in particular corresponding to the degree of enlargement.

11. Magnetic resonance facility (16), which has a gradient coil arrangement (19) for generating gradient fields to be used during the magnetic resonance scan for spatial encoding and a control facility (20), wherein the control facility (20) is designed for distortion correction on the basis of a distortion map (25) of acquired magnetic resonance data sets at least for distortions caused by imperfections in the gradient fields, **characterised in that** the control facility (20) is designed for carrying out a method according to one of the preceding claims.

12. Computer program, which carries out the steps of a method according to one of claims 1 to 10 when it is run on a control facility (20) of a magnetic resonance facility (16).

13. Electronically readable data carrier on which a computer program according to claim 12 is stored.

## Revendications

1. Procédé mis en œuvre par ordinateur de réglage d'un champ de vision pour un enregistrement par résonnance magnétique, en particulier d'un patient, par un dispositif (16) à résonnance magnétique, qui a un agencement (19) de bobines de gradient, pour la production de champs de gradient à utiliser pour le codage spatial à l'enregistrement par résonnance magnétique, et un dispositif (20) de commande, dans lequel le dispositif (20) de commande est constitué pour, à l'aide d'une carte (25) de distorsion, la correction de distorsion d'ensembles de données de résonnance magnétique enregistrés, au moins pour des distorsions provoquées par des imperfections des champs de gradient, dans lequel, par le dispositif (20) de commande
- sur la base de la carte (25) de distorsion, on détermine pour au moins un premier ensemble (9) de paramètres de champ de vision décrivant un champ (1) de vision rectangulaire ou parallélépipédique d'origine, une information d'exclusion décrivant une partie (7), non reproduite en raison de la distorsion, du champ (1) de vision d'origine,
- en utilisant l'information d'exclusion, on détermine un deuxième ensemble (11) de paramètres de champ de vision à utiliser pour l'enregistrement par résonnance magnétique, et
- l'enregistrement par résonnance magnétique s'effectue en utilisant le deuxième ensemble (11) de paramètres de champ de vision,
**caractérisé en ce que** l'on affiche sur un dispositif (22) d'affichage le champ (1) de vision d'origine à régler dans une surface (10) d'utilisateur, en particulier conjointement avec une anatomie (2) du patient à enregistrer, dans lequel on utilise l'information d'exclusion, pour l'affichage de la partie (7) non reproduite suivant l'information d'exclusion et/ou pour l'adaptation de la démarcation (1') de l'affichage de champ de vision pour l'exclusion de la partie (7) non reproduite, dans lequel, s'il se produit une modification du champ (1) de vision à régler, en raison d'une entrée de l'utilisateur, on utilise les paramètres de champ de vision, décrivant le champ (1) de vision modifié à régler, comme nouveau premier ensemble (9) pour la mise à jour de l'information d'exclusion, puis on affiche, pour le champ (1) de vision modifié à régler, la partie (7) non reproduite sur la base de l'information d'exclusion mise à jour.

2. Procédé suivant la revendication 1, **caractérisé en ce que** la détermination du deuxième ensemble (11) de paramètres de champ de vision s'effectue sur la base d'une sélection par l'utilisateur d'un champ (1, 15) de vision dans un affichage suivant la revendication 1, en particulier comme le champ de vision sélectionné.

3. Procédé suivant la revendication 2, **caractérisé en ce que**, sur la base d'un choix par l'utilisateur du champ (1) de vision d'origine, on détermine, par le dispositif (20) de commande, automatiquement un deuxième ensemble (11) de paramètres de champ de vision, de manière à ce que la partie (8) représentée du champ (15) de vision associé comprenne tout le champ (1) de vision d'origine sélectionné.

4. Procédé suivant la revendication 3, **caractérisé en ce qu'**un agrandissement pas à pas, à partir du champ (1) de vision d'origine sélectionné, dans au moins une dimension, dans laquelle il y a au bord la partie (7) non reproduite, est effectué pour la sélection de premiers ensembles (9) de paramètres de vision à contrôler jusqu'à trouver un deuxième ensemble (11) approprié de paramètres de champ de vision, ou **en ce que** la détermination de la partie (7) non reproduite s'effectue par application de la correction de distorsion inverse suivant la carte (25) de distorsion sur le champ (1) de vision d'origine et on sélectionne le deuxième ensemble (11) de paramètres de champ de vision, de manière à ce que le champ (15) de vision leur appartenant comprenne complètement le résultat de l'application.

5. Procédé suivant l'une des revendications précédentes, **caractérisé en ce que**, sur la base d'une information (12) de recherche décrivant des caractéristiques (3) à montrer sur un enregistrement par résonnance magnétique, en particulier des caractéristiques (3) anatomiques, on contrôle, par le dispositif (20) de commande automatiquement, à partir d'un champ (1) de vision d'origine contenant ces caractéristiques (3) sans prise en compte de la distorsion et/ou sélectionnées par l'utilisateur, si la partie (8) reproduite de ce champ (1) de vision d'origine comprend toutes les caractéristiques (3) à montrer, dans lequel, si la partie (8) reproduite ne comprend toutes les caractéristiques (3) à montrer
- on détermine automatiquement un deuxième ensemble (11) de paramètres de champ de vision, de manière à ce que la partie (8) reproduite du champ (15) de vision leur appartenant comprenne toutes les caractéristiques (3) à montrer, et/ou
- on émet une indication d'alerte de l'utilisateur.

6. Procédé suivant l'une des revendications précédentes, **caractérisé en ce que** le premier ensemble (9) de paramètres de vision décrit un champ (1) de vision d'origine utilisé d'un enregistrement par résonnance magnétique déjà effectué, dans lequel, par le dispositif (20) de commande, on évalue automatiquement un critère d'action, qui contrôle, si la proportion de la partie (7) non reproduite du champ (1) de vision utilisé dépasse, sans la prise en compte de la distorsion, une valeur de seuil et/ou au moins une caractéristique (3) à montrer dans l'enregistrement par résonnance magnétique suivant une ou l'information (12) de recherche se trouve au moins en partie dans la partie (7) non reproduite, dans lequel, si le critère d'action est satisfait, on détermine automatiquement un deuxième ensemble (11) de paramètres de champ de vision à utiliser pour un enregistrement par résonnance magnétique encore à effectuer, de manière à ce que la proportion de la partie (7) non reproduite du champ (1) de vision d'origine utilisé devienne, sans prise en compte de la distorsion, inférieure à une autre ou à la valeur de seuil et/ou de manière à ce que la partie (8) reproduite du champ (15) de vision appartenant au deuxième ensemble (11) de paramètres de champ de vision comprenne toutes les caractéristiques (3) à montrer.

7. Procédé suivant l'une des revendications précédentes, **caractérisé en ce que** la détermination de la partie (7) non reproduite s'effectue par l'application de la correction inverse de distorsion suivant la carte (25) de distorsion sur une image (13) de masque du champ (1) de vision d'origine pour la détermination d'une image (14) de résultat, dans lequel on identifie les proportions, se trouvant à l'extérieur du champ (1) de vision d'origine sans prise en compte de la distorsion de l'image (14) de résultat, comme une partie (7) non reproduite.

8. Procédé suivant la revendication 7, **caractérisé en ce que** l'on détermine l'image (13) de masque sur la base d'un modèle et/ou d'un enregistrement par résonnance magnétique déjà effectué, de manière à ce qu'elle indique où se trouve, dans le champ (1) de vision d'origine sans prise en compte de la distorsion des proportions, en particulier à enregistrer, en particulier des caractéristiques (3) à montrer, du patient, dans lequel, pour la détermination de la partie (7) non reproduite, on ne prend en compte que des proportions à enregistrer du patient suivant l'image (13) de masque.

9. Procédé suivant la revendication 7 ou 8, **caractérisé en ce que** l'on détermine automatiquement un deuxième ensemble (11) de paramètres de champ de vision en déterminant, à partir du champ (1) de vision d'origine, un deuxième champ (15) de vision agrandi, de manière à ce qu'il comprenne la partie (7) non reproduite.

10. Procédé suivant l'une des revendications précédentes, **caractérisé en ce que**, dans l'agrandissement du champ (15) de vision décrit par le deuxième ensemble (11) de paramètres de champ de vision, on augmente la résolution par rapport au champ (1) de vision d'origine, en particulier en fonction du degré de l'agrandissement.

11. Dispositif (16) à résonnance magnétique, qui a un agencement (19) de bobines de gradient pour la production de champs de gradient à utiliser pour le codage spatial à l'enregistrement par résonnance magnétique et un dispositif (20) de commande, dans lequel le dispositif (20) de commande est, à l'aide d'une carte (25) de distorsion, constitué pour la correction de distorsion d'ensembles de données de résonnance magnétique enregistrés au moins pour des distorsions provoquées par des imperfections des champs de gradient, **caractérisé en ce que** le dispositif (20) de commande est constitué pour effectuer un procédé suivant l'une des revendications précédentes.

12. Programme d'ordinateur, qui effectue les stades d'un procédé suivant l'une des revendications 1 à 10, lorsqu'il est réalisé sur un dispositif (20) de commande d'un dispositif (16) à résonnance magnétique.

13. Support de données, déchiffrable électroniquement, sur lequel un programme d'ordinateur suivant la revendication 12 est mis en mémoire.
